# EUROPEAN PATENT SPECIFICATION

(11) **EP 3 660 923 B1**
(45) Date of publication and mention of the grant of the patent: **03.04.2024**
(21) Application number: 19212334.7
(22) Date of filing: 28.11.2019
(51) Int. Cl.: H01L 29/40, H01L 29/417, H01L 21/441, H01L 21/18, H01L 21/285, H01L 29/45, H01L 29/20, H01L 29/778

(54) **METHOD FOR MANUFACTURING AN OHMIC CONTACT FOR A HEMT DEVICE**
VERFAHREN ZUR HERSTELLUNG EINES OHMSCHEN KONTAKTS FÜR EINE HEMT-VORRICHTUNG
PROCÉDÉ DE FABRICATION D'UN CONTACT OHMIQUE POUR UN DISPOSITIF HEMT

(30) Priority: 28.11.2018 IT 201800010656
(43) Date of publication of application: 03.06.2020
(73) Proprietor: STMicroelectronics S.r.l., 20864 Agrate Brianza (MB) (IT)
(72) Inventor: IUCOLANO, Ferdinando, 95030 GRAVINA DI CATANIA (CT) (IT); TRINGALI, Cristina, 96011 AUGUSTA (SR) (IT)
(74) Representative: Studio Torta S.p.A.

(56) References cited:
- TW-A- 200 949 953
- US-A1- 2004 094 759
- US-A1- 2012 205 663
- US-A1- 2017 194 195
- LIU C. H. ET AL: "Bimetallic structure fabricated by laser interference lithography for tuning surface plasmon resonance", OPTICS EXPRESS, vol. 16, no. 14, 7 July 2008 (2008-07-07), page 10701, XP055907408, US ISSN: 2161-2072, DOI: 10.1364/OE.16.010701

## Description

The present invention relates to a method for manufacturing an ohmic contact for a field-effect transistor with high electron mobility, known as HEMT (High Electron Mobility Transistor). In particular, the present invention discusses a procedure for self-alignment of a gold-free ohmic contact, which can be applied, for example, to source contacts and drain contacts of the HEMT device.

As is known, a HEMT device comprises a heterostructure that has an interface between two different semiconductor materials, such as aluminium and gallium nitride (AlGaN) and gallium nitride (GaN). When the HEMT device is appropriately biased, a layer of 2D electron gas (2DEG) is induced at said interface.

The 2DEG layer represents an electron cloud with high charge density in which the charges possess high mobility. Such properties render the HEMT device attractive for radiofrequency (RF) applications and in power electronics.

Generally, the HEMT device comprises ohmic contacts for the source and drain terminals that are made of gold so as to enable low contact and access resistances to be achieved (c.f. Ferdinando Iucolano, Giuseppe Greco, and Fabrizio Roccaforte - Applied Physics Letters 103, 201604 (2013); doi: 10.1063/1.4828839).

The method for manufacturing gold ohmic contacts typically includes deposition of a sequence of metal layers on a semiconductor body formed by a stack including a substrate, a GaN layer and an AlGaN layer. The GaN and AlGaN layers form the heterostructure.

The above sequence of metal layers is obtained with known processes (such as lithographic and lift-off steps) and comprises a titanium (Ti) layer in contact with the surface of the semiconductor body, an aluminium (Al) layer on the titanium layer, a nickel (Ni) layer on the aluminium layer, and a deposition of gold (Au) on the nickel layer. The first three layers referred to above are adapted, in a known way, to promote adhesion of the gold (which functions as central body of the ohmic contact) to the semiconductor body.

The method for manufacturing gold ohmic contacts requires a thermal annealing process at high temperatures (for example, higher than 800°C). In these temperature conditions, Ti reacts with the N₂ available in the GaN, to form titanium nitride. Charge transport is thus guided by a metal-like behaviour of TiN due to intrusions of the metal in the 2DEG region. Formation of a gold contact is not in any case easy to implement on a CMOS line on account of the metallic contamination generated by gold, which would require dedicated equipment and segregated production areas.

A commonly used alternative approach is to resort to gold-free ohmic contacts, where the central body of the ohmic contact is made of titanium and aluminium.

The absence of gold in the ohmic contacts enables reduction of the annealing temperature to 600°C and use of techniques such as rapid thermal annealing (RTA). In particular, the RTA technique reduces the mechanical stresses to which the semiconductor body with ohmic contact is subjected and prevents formation of states of charge trap, thus improving the efficiency and productivity of the manufacturing process and of the HEMT device itself.

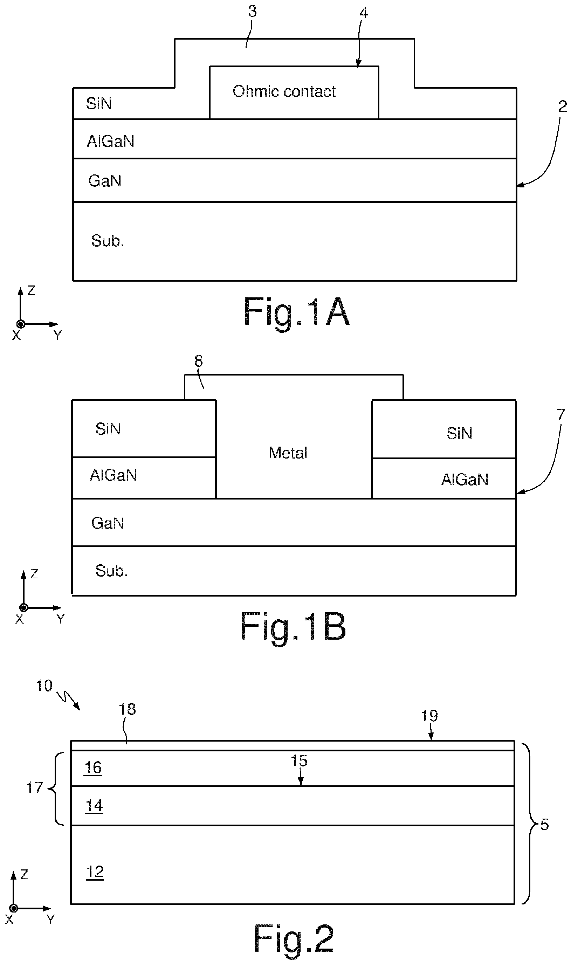

Various ohmic-contact physical structures of the gold-free type are known in the prior art. In particular, two of them are illustrated, in a side section view, in Figures 1A and 1B.

Figure 1A shows an ohmic-contact structure 4 in a HEMT device of a known type, with non-recessed semiconductor body 2 (Jing-Neng Yao, et al., "An Au-free GaN High Electron Mobility Transistor with Ti/Al/W Ohmic Metal Structure", IEEE, 2015). A passivation layer 3, for example of SiN, extends over the semiconductor body 2 and in particular on the ohmic contact 4, to protect the latter.

Figure 1B shows an ohmic-contact structure 6 in a HEMT device of a known type, with recessed semiconductor body 7 (W. H. Tham, et al., "AlxGa1-xN/GaN MISHEMTs with a common gold-free metal-stack for source/drain/gate", IEEE ELECTRON DEVICE LETTERS, VOL. 36, No. 12, DECEMBER 2015). A dielectric layer 8, for example of SiN, extends over the semiconductor body 7. The ohmic contact 6 extends through the dielectric layer 8.

The process for manufacturing the ohmic contact 6, recessed in the semiconductor body 7 (Figure 1B) proves to be more complex than the process for obtaining the non-recessed ohmic-contact structure 4 (Figure 1A). However, the electrical performance achieved by the HEMT device of the type illustrated in Figure 1B proves to be higher than the electrical performance achieved by the HEMT device of Figure 1A, and moreover presents better reproducibility and reliability.

In addition, the use of passivating material (here, SiN) for protecting the ohmic contacts 4 and 6 causes a greater dispersion of the values of contact resistance thereof.

The patent document US2012/205663 describes a HEMT semiconductor device and a manufacturing method thereof. However, said document does not describe in detail a method for forming an ohmic contact capable of overcoming the drawbacks listed above.

The patent document US2004/094759 refers to a process for the manufacturing of ultra-low contact resistances in Gan-based HEMT devices. The process provides for an annealing of the contact metallisations at a high temperature, with the relative metallisations that penetrate inside the semiconductor body, thus making the structure peculiar. Furthermore, the use of gold makes the process unsuitable in CMOS production lines.

Further lift-off processes for manufacturing of electrodes are described in patent documents US2004094759 A1; US2012205663 A1; US2017194195 A1; and TW200949953 A.

The aim of the present invention is to provide a method for manufacturing an ohmic contact for a HEMT device that will overcome the limitations of the prior art.

According to the present invention a method for manufacturing an ohmic contact for a HEMT device is provided, as defined in claim 1.

For a better understanding of the present invention, a preferred embodiment is now described purely by way of nonlimiting example, with reference to the attached drawings, wherein:
- Figures 1A and 1B show, in side section views of a respective HEMT device with non-recessed ohmic contacts and with ohmic contacts recessed in a semiconductor body, respectively, according to embodiments of a known type;
- Figures 2-6 show, in a side section view, manufacturing steps for obtaining a HEMT device with ohmic contact recessed in a semiconductor body, according to an example not forming part of the present invention;
- Figures 7-10 illustrate a variation of the manufacturing steps 3A-5; and
- Figure 11 illustrates a variation of the manufacturing steps 3A-5, leading to an embodiment of the invention as claimed.

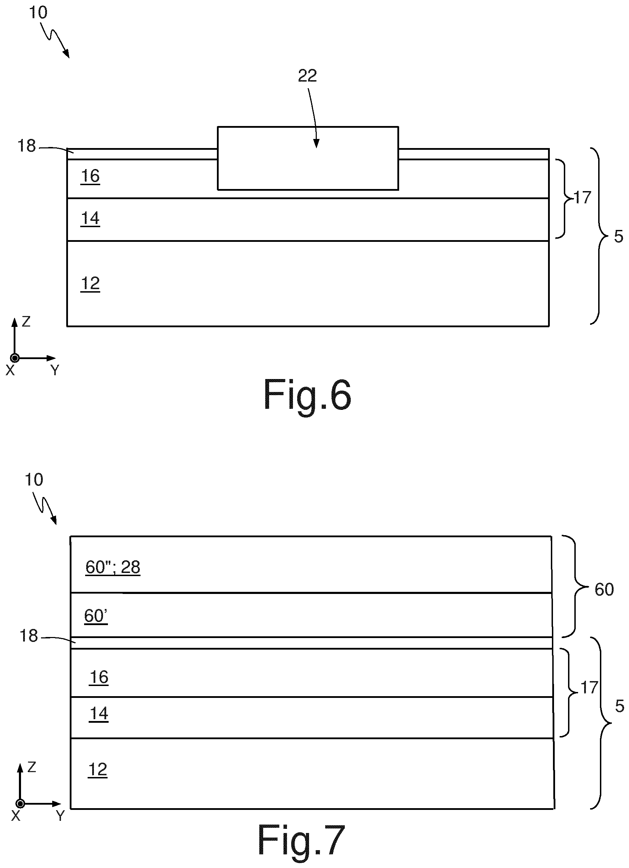

Figures 2-6 illustrate, in a side section view, in a triaxial cartesian reference system X, Y, Z, manufacturing steps for obtaining an ohmic-contact structure 10, of a recessed type, illustrated, as a whole, in Figure 6. The structure 1 forms part of a HEMT device.

With reference to Figure 2, a substrate 12 of semiconductor material, such as silicon, or silicon carbide (SiC), or sapphire (Al₂O₃), or some other material, is provided.

Formed on the substrate 12, in succession and in a way in itself known, along the direction of the axis Z are, respectively: a first structural layer 14, in particular of intrinsic gallium nitride (GaN) (channel layer of the HEMT device), grown, for example epitaxially, on the substrate 12; a second structural layer 16, in particular of intrinsic aluminium and gallium nitride (AlGaN) or, more in general, of compounds based upon ternary or quaternary alloys of gallium nitride, such as AlₓGa₁₋ₓN, AlInGaN, InₓGa₁₋ₓN, AlₓIn₁₋ₓAl (barrier layer of the HEMT device), grown, for example epitaxially, on the channel layer 14; and a protection layer 18, in particular of GaN with a thickness of just a few nanometres (e.g., 1-4 nm), having the function of protecting the barrier layer 16 from oxidation phenomena.

The channel layer 14 and the barrier layer 16 form, in a way in itself known, a heterostructure 17.

In a way not illustrated in the Figure, between the substrate 12 and the channel layer 14 one or more further buffer layers may be present, according to the need.

The channel layer 14 has a thickness (along the axis Z), for example approximately between 1 µm and 5 pm; the barrier layer 16 has a thickness (along the axis Z), for example approximately between 5 nm and 30 nm.

A 2DEG layer 15 is formed at the interface between the channel layer 14 and the barrier layer 16. The charge carriers belonging to the 2DEG are free to move in any direction in a plane XY (defined by the axes X and Y) at the 2DEG interface 15, whereas they are confined along the axis Z.

The substrate 12, the channel layer 14, the barrier layer 16, and the protection layer 18 form a semiconductor body 5.

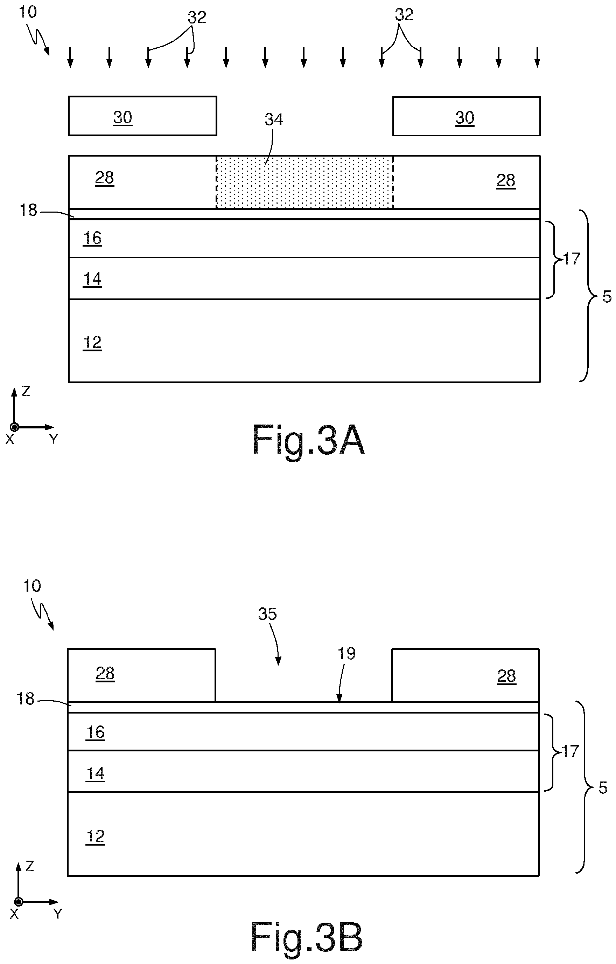

With reference to Figure 3A, a photoresist layer 28, with a thickness, for example, of between 1 and 3 um is deposited. Said photoresist layer 28 entirely and evenly coats the protection layer 18.

This is then followed by a step of photolithographic exposure (represented by the arrows 32) of the photoresist layer 28, via the use of a mask 30. The regions of the photoresist layer 28 not covered by the mask 30 thus become soluble during the subsequent etching step.

The mask 30 is such that a region 34 of the photoresist layer 28 is exposed. Said region 34 defines the region in which the ohmic contact will be provided.

Then (Figure 3B), the mask 30 is removed, and an etching step (e.g., of a wet type) is carried out for selective removal of the region 34 of the photoresist layer 28. A trench 35 is thus formed in the photoresist layer 28, through which a surface portion 19 of the protection layer 18 is exposed. It may be noted that the process described with reference to Figures 3A-3B does not require the deposition of a layer of passivating material (such as, for example, silicon nitride) as is typically envisaged in the prior art.

The photolithographic steps listed above have been described with reference to a positive photoresist. A different embodiment, not illustrated, envisages the use of a negative photoresist, as described with reference to Figures 7-10, or of a bi-layer.

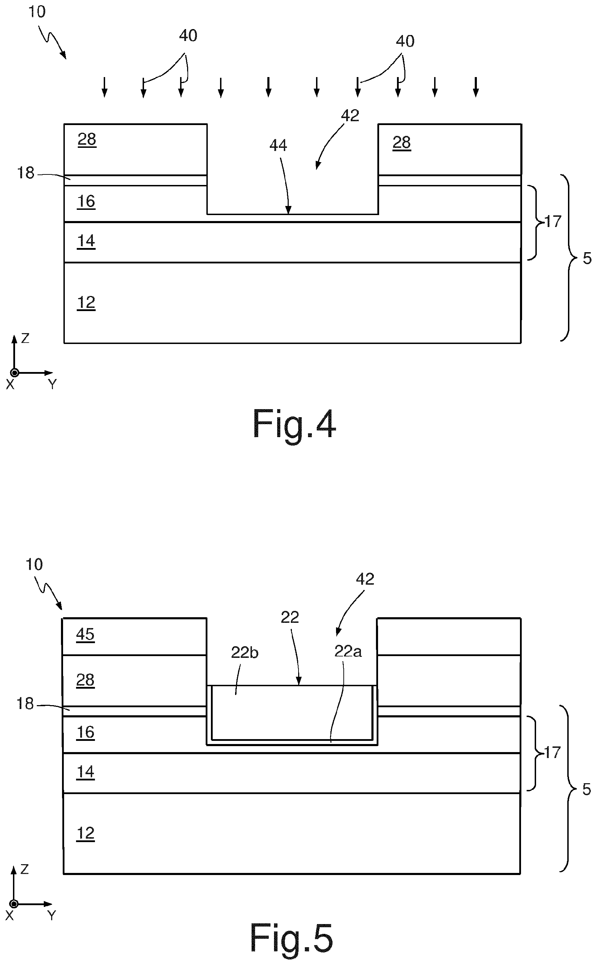

With reference to Figure 4, an etch is then carried out (represented by arrows 40) for selective removal of portions of the protection layer 18 and of the underlying barrier layer 16, which are exposed through the trench 35. More in particular, the etching process comprises a first step, for removing the protection layer 18, and a second step, for partly or completely removing the barrier layer 16. Both of these steps use a Cl₂-based chemistry.

The photoresist layer 28 functions as etching mask, for protecting the regions of the semiconductor body 5 not exposed through the trench 35.

At the trench 35, the semiconductor body 5 is then dug further, to form a contact trench 42, which extends in depth in the barrier layer 16, terminating inside the barrier layer 16 itself. The contact trench 42 is delimited underneath by a bottom surface 44 of the barrier layer 16.

The contact trench 42 is adapted to house an ohmic contact, as described hereinafter.

With reference to the etching process 40, the first etching step is designed to remove the protection layer 18 throughout its entire thickness in the area exposed by the trench 35, whereas the second etching step is designed to remove only part of the thickness, along Z, of the barrier layer 16.

It is moreover evident that, in other embodiments, the contact trench 42 may extend throughout the entire thickness of the barrier layer 16, terminating at the interface with the underlying layer (here, the substrate 12), or else proceeding into the underlying layer, according to the design needs and parameters.

With reference to Figure 5, there then follows deposition of one or more layers of conductive material, in particular one or more metal layers, via known techniques, such as sputtering or evaporation. In particular, a stack of metal layers is formed (three of which are illustrated in Figures 5 and 6) adapted to form an ohmic contact 22.

Formation of the stack of metal layers comprises, according to one embodiment, forming a first interface layer 22a and a filling layer 22b on the interface layer 22a. The interface layer 22a is made of a material chosen from titanium or tantalum. The filling layer 22b is, in particular, made of aluminium.

Formation of the stack of metal layers comprises, according to a further embodiment, forming in succession a first titanium or tantalum layer, an aluminium layer, and a second layer, which is also made of titanium or tantalum. The Ti layer is adapted to promote the adhesion of the nickel or tungsten layer to the bottom surface 44 of the contact trench 42 (i.e., to the barrier layer 16) and has the function of interface layer 22a. The Al layer functions, instead, as filling layer 22b, or central body, of the ohmic contact 22. The last Ti or Ta layer serves as packaging layer.

It is evident that other materials, or a different number of layers, may be used to form the stack of the ohmic contact 22, according to the design specifications. For instance, it is possible to omit the interface layer 22a by depositing just the filling layer 22b, which, in this case, is made of aluminium.

The one or more conductive materials for formation of the ohmic contact 22 are both deposited inside the trench 42 and on the outside thereof, over the photoresist layer 28, which is thus covered at the top by a spurious metal deposition 45.

This is followed by a lift-off step, for removing both the photoresist layer 28 and the spurious metal material 45.

A step of rapid thermal annealing (RTA) is then carried out, which enables perfecting of the ohmic contact, in a way in itself known. This procedure is conducted at a temperature ranging between approximately 450°C and approximately 650°C, in protected environment (for example, in a nitrogen or argon atmosphere).

Figure 6 shows the structure 10 at the end of the manufacturing steps described, which includes the recessed gold-free ohmic contact 22.

As may be seen, the ohmic contact 22 is automatically aligned, or self-aligned, to the recessed region formed previously in the heterostructure 17.

This result is achieved by using the same photoresist layer 28 in two different steps of the manufacturing process. Firstly, the photoresist layer 28 is used during etching 40 as a mask for creation of the contact trench 42 (and hence for defining the recessed region in the heterostructure 17). Moreover, the photoresist layer 28 is used as a further mask for forming the ohmic contact 22, by deposition of metal material.

From an examination of the characteristics of the invention provided according to the present disclosure the advantages that it affords are evident.

In particular it is possible to obtain gold-free ohmic contacts that present lower contact and access resistances, and the electrical performance of which is highly reproducible.

The manufacturing process is simplified via the use of the photoresist layer as mask both during the etching step and during metal deposition of the ohmic contact. The ohmic contact is thus automatically aligned with the recessed AlGaN region. This enables better electrical performance to be achieved by the HEMT device and reduction of the related production costs, as well as guaranteeing structural quality of the ohmic contact.

Having a low contact resistance enables a higher maximum current through the HEMT device, and hence a higher output power, to be obtained.

A low contact resistance is moreover fundamental in radiofrequency applications for improving the frequency response of the HEMT device.

According to the present invention, a passivation layer is not necessary for formation of the metal contact. The absence of passivating material in the process for manufacturing the ohmic contact enables a lower spread of the values of contact resistance to be obtained, thus improving the electrical properties of the HEMT device.

The invention described herein hence reduces the costs for manufacturing the ohmic contacts, rendering the manufacturing process compatible with CMOS technology.

Finally, it is clear that modifications and variations may be made to the invention described and illustrated herein, without thereby departing from the scope of protection thereof, as defined in the annexed claims.

In particular, the steps of the formation of the trench through a photoresist layer 28, of the deposition of the ohmic contact 22, and the subsequent step of lift-off to remove both the photoresist layer 28 and the spurious metal material 45, described with reference to Figures 3A-5, can be replaced by the steps according to Figures 7-9 described hereinafter (structural elements, or process steps, found in Figures 3A-5 are not further described, and the same reference numbers will be used).

With reference to Figure 7, a stack 60 of sacrificial layers is formed. In particular the following are formed:
- a first sacrificial layer 60', of a nonphotosensitive (or non-photoimageable) organic polymer solution, in particular, known commercially as "PMGI", or "SF11" (concerning a resist including a polydimethyl glutarimide polymer), with a thickness comprised between 0.6 µm and 1.3 µm (according to the subsequent thickness of metal that must be evaporated); and
- a second sacrificial layer 60", of photosensitive or photoimageable material (i.e., photoresist), which extends over the first sacrificial layer 60', with a thickness comprised between 0.6 µm and 4 µm.

Both the first and second sacrificial layers 60', 60" can be formed by spin-coating technique.

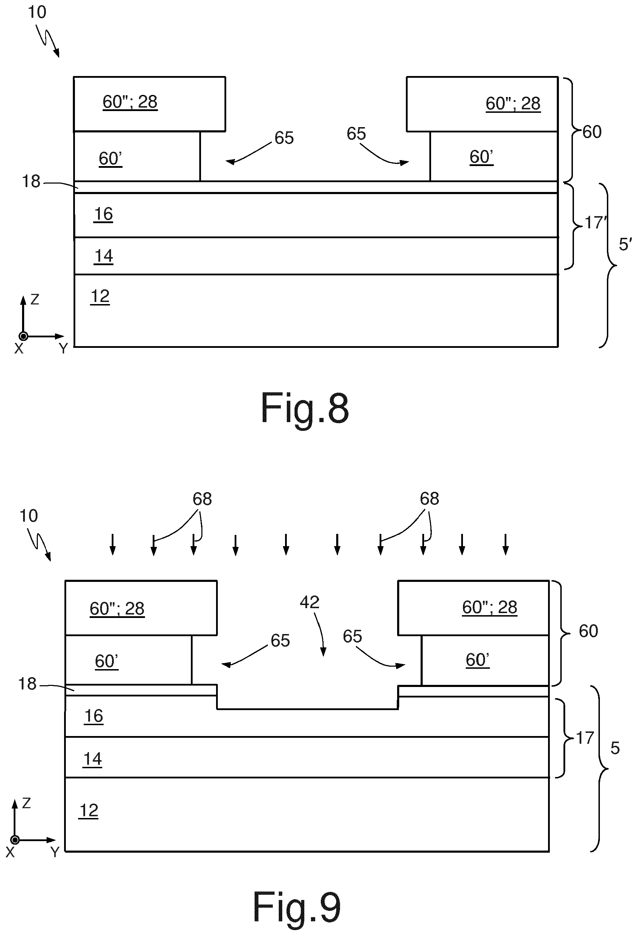

In the following, (Figure 8), the second sacrificial layer 60" is patterned, by a lithographic and development step, to remove selective portions of the sacrificial layer 60" at the region of the structure 10 in which it is desired to form the ohmic contact 22. Since the first sacrificial layer 60' is not photosensitive, the lithographic and development step of the second sacrificial layer 60" has no effect on the first sacrificial layer 60'. At the end of the development of the second sacrificial layer 60" (i.e., by TMAH), the first sacrificial layer 60' is partially exposed at the regions of the second sacrificial layer 60" removed. During this step, also the isotropic etching of the first sacrificial layer 60' takes place, to uniformly remove the regions of the first sacrificial layer 60' exposed. Since the etching is of isotropic type, a removal of the first sacrificial layer 60' can also be seen below the second sacrificial layer 60" (namely, an underetch or undercut phenomenon), that extends towards the source and drain regions, without reaching them. In the section view of Figure 8, undercut regions 65 extend, along the direction Y.

Following this step, the stack 60 remains on the structure 10, covering it, with the exception of regions where it is desired to form the ohmic contact 22.

This is followed, (Figure 9), by an etching (illustrated by arrows 68 in Figure 9) to remove selective portions of the protection layer 18 and of the underlying barrier layer 16, similarly to what is described with reference to Figure 4. More in particular, the etching comprises a first step, to remove the protection layer 18, and a second step, to partially or completely remove the barrier layer 16. Both of the steps use a Cl₂-based chemistry. The second sacrificial layer 60" defines the etching mask, and in particular the exposed portions of the protection layer 18 and of the barrier layer 16 are removed through the opening defined in the step of Figure 8 through the second sacrificial layer 60". Thus forming a trench similar to the trench 42 already described with reference to Figure 4, and therefore illustrated herein with the same reference number.

In particular, it may be noted that the second sacrificial layer 60" can correspond in terms of material, thickness and functional characteristics to the photoresist layer 28 previously described.

Then, (Figure) 10, a step for the formation of the stack of metal layers which form the ohmic contact 22 takes place, as described with reference to Figure 5 (comprising forming the first interface layer 22a and the filling layer 22b), in particular through evaporation processes. The sacrificial layer 60" is used as a deposition mask; the layers 22a, 22b deposited are therefore self-aligned.

The one or more conductive materials for the formation of the ohmic contact 22 are both deposited inside the trench 42 and on the outside thereof, over the second sacrificial layer 60", which is covered at the top by a spurious metal deposition 45.

Then, by a lift-off process of a per se known type, the first and the second sacrificial layers 60', 60" are removed, together with the spurious metal deposition 45. The presence of the undercut regions 65 is advantageous during this lift-off step, since this conformation prevents the deposition of a uniform metal layer along the vertical walls of the first sacrificial layer 60', thus promoting the lift-off.

The structure 10, illustrated in Figure 6, is thus obtained.

In a further example not forming part of the present invention, the steps of Figures 7-10 are carried out on a semiconductor body that does not have the protection layer 18, therefore, the stack 60 is formed directly on the barrier layer 16.

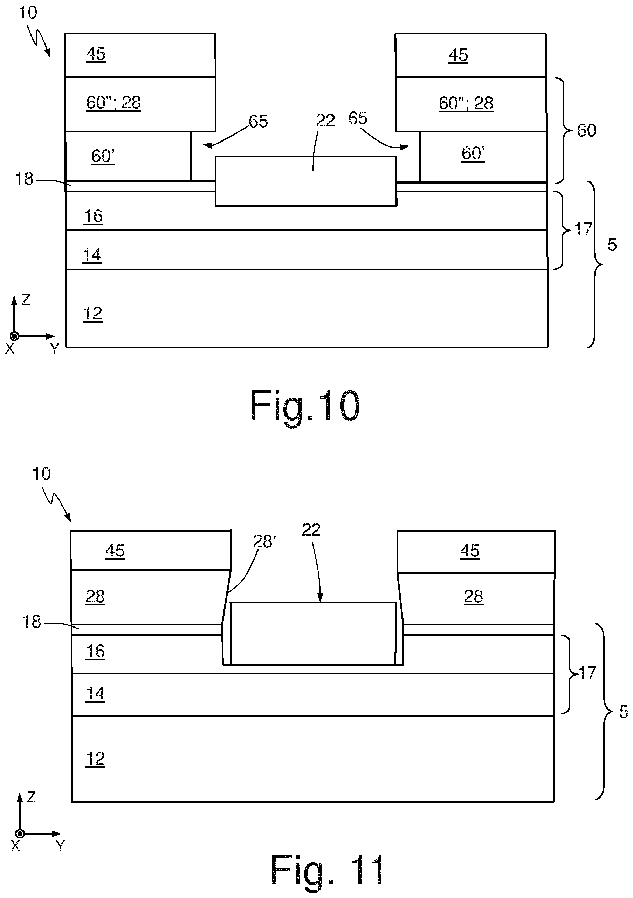

In an embodiment according to the invention as claimed, illustrated in Figure 11, the photoresist layer 28 is formed with tilted side walls 28' (forming a structure of a truncated cone type with a larger base at the layer 18). The deposition, i.e., by evaporation, of one or more layers for forming the ohmic contact 22, is typically carried out substantially along the vertical direction (axis Z). Consequently, the projection of the tilted side walls 28' would allow formation of the ohmic contact 22 in the trench 42 without having to be in direct contact with the tilted side walls 28' or the side walls of the layers 16, 18 and therefore, without forming a layer of spurious metal material along the sides of any one of the layers 16, 18, 28.

## Claims

1. A method for manufacturing an ohmic contact (22) for a HEMT device (1), comprising the steps of:
- forming a sacrificial structure (28; 60) on a semiconductor body (5) comprising a heterostructure (17);
- forming, through the sacrificial structure (28; 60), an opening (35; 42), through which a surface region (19) of the semiconductor body (5) is exposed at said heterostructure (17);
- etching the surface region (19) of the semiconductor body (5) using said sacrificial structure (28; 60) as etching mask to form a trench (42) in the heterostructure (17);
- depositing one or more metal layers (22a, 22b; 22) in said trench (42) and on the sacrificial structure (28; 60); and
- carrying out a lift-off process of the sacrificial structure (28; 60),
wherein the semiconductor body (5) comprises a substrate (12), a channel layer (14) on the substrate (12), a barrier layer (16) on the channel layer (14), and a protection layer (18) on the barrier layer (16) configured to protect the barrier layer (16) from oxidation phenomena,
said trench (42) being formed throughout the thickness of the protection layer (18) and through at least part of the barrier layer (16),
the sacrificial structure (28; 60) being formed on the protection layer (18),
wherein the sacrificial structure (28; 60) comprises a photoresist layer (28; 60"), and the step of depositing said one or more metal layers (22a, 22b; 22) comprises using the photoresist layer (28; 60") as deposition mask,
wherein the step of using the photoresist layer (28) as deposition mask comprises shaping the photoresist layer in order to form a through-opening through the photoresist layer, said through-opening being delimited by tilted side walls (28') conferring to the photoresist layer (28) a truncated cone shape with a larger base at the protection layer (18), the tilted side walls being tilted with respect to a vertical direction (Z),
and wherein depositing one or more metal layers (22a, 22b; 22) in said trench (42) is carried out substantially along said vertical direction (Z), so that the projection of the tilted side walls (28') allows formation of the one or more metal layers (22a, 22b; 22) in the trench (42) that are not in direct contact with the tilted side walls (28'), nor with the side walls of the underlying protection layer (18) and barrier layer (16).

2. The method according to claim 1, wherein the step of forming the sacrificial structure (60) further comprises forming a sacrificial layer (60') of a non-photoimageable material below the photoresist layer (28; 60"),
and wherein the step of forming said opening (35; 42) comprises:
carrying out a photolithographic process to remove selective portions of the photoresist layer (28; 60"), until reaching the first sacrificial layer (60'); and
isotropically etching the first sacrificial layer (60') by forming an undercut region (65) between the photoresist layer (28; 60") and the semiconductor body (5).

3. The method according to claim 1 or claim 2, wherein the step of depositing said one or more metal layers comprises forming a stack including at least one metal interface layer (22a) in contact with said heterostructure (17) and at least one metal filling layer (22b) on the metal interface layer (22a).

4. The method according to claim 3, wherein the step of forming the metal interface layer (22a) includes depositing a layer of a material chosen from titanium and tantalum; and the step of forming the metal filling layer (22b) includes depositing an aluminium layer.

5. The method according to anyone of the preceding claims, further comprising the step of carrying out a process of rapid thermal annealing, RTA, of said one or more metal layers.

6. The method according to claim 5, wherein the RTA process is carried out at a temperature ranging between 450°C and 650°C.

## Patentansprüche

1. Verfahren zum Herstellen eines ohmschen Kontakts (22) für eine HEMT-Vorrichtung (1), umfassend die folgenden Schritte:
- Bilden einer Opferstruktur (28; 60) auf einem Halbleiterkörper (5), der eine Heterostruktur (17) umfasst;
- Bilden einer Öffnung (35; 42), durch die ein Oberflächengebiet (19) des Halbleiterkörpers (5) an der Heterostruktur (17) freigelegt ist, durch die Opferschicht (28; 60);
- Ätzen des Oberflächengebiets (19) des Halbleiterkörpers (5) unter Verwendung der Opferstruktur (28; 60) als Ätzmaske, um einen Graben (42) in der Heterostruktur (17) zu bilden;
- Abscheiden einer oder mehrerer Metallschichten (22a, 22b; 22) im Graben (42) und auf der Opferstruktur (28; 60); und
- Ausführen eines Abhebeverfahrens der Opferstruktur (28; 60),
wobei der Halbleiterkörper (5) ein Substrat (12), eine Kanalschicht (14) auf dem Substrat (12), eine Sperrschicht (16) auf der Kanalschicht (14) und eine Schutzschicht (18) auf der Sperrschicht (16), die dazu konfiguriert ist, die Sperrschicht (16) vor Oxidationserscheinungen zu schützen, umfasst,
wobei der Graben (42) durch die ganze Dicke der Schutzschicht (18) hindurch und durch mindestens einen Teil der Sperrschicht (16) gebildet ist,
wobei die Opferstruktur (28; 60) auf der Schutzschicht (18) gebildet ist,
wobei die Opferstruktur (28; 60) eine Fotolackschicht (28; 60") umfasst, und der Schritt des Abscheidens der einen oder mehreren Metallschichten (22a, 22b; 22) das Verwenden der Fotolackschicht (28; 60") als Abscheidungsmaske umfasst,
wobei der Schritt des Verwendens der Fotolackschicht (28) als Abscheidungsmaske das Formen der Fotolackschicht umfasst, um eine Durchgangsöffnung durch die Fotolackschicht zu bilden, wobei die Durchgangsöffnung durch geneigte Seitenwände (28') begrenzt ist, die der Fotolackschicht (28) eine kegelstumpfförmige Form mit einer größeren Basis an der Schutzschicht (18) verleihen, wobei die geneigten Seitenwände in Bezug auf eine vertikale Richtung (Z) geneigt sind,
und wobei das Abscheiden einer oder mehrerer Metallschichten (22a, 22b; 22) im Graben (42) im Wesentlichen entlang der vertikalen Richtung (Z) ausgeführt wird, so dass der Schutz der geneigten Seitenwände (28') die Bildung der einen oder mehreren Metallschichten (22a, 22b; 22) im Graben (42) ermöglichen, die weder in direktem Kontakt mit den geneigten Seitenwänden (28') noch mit den Seitenwänden der darunterliegenden Schutzschicht (18) und Sperrschicht (16) stehen.

2. Verfahren nach Anspruch 1, wobei der Schritt des Bildens der Opferstruktur (60) ferner das Bilden einer Opferschicht (60') eines nicht fotostrukturierbaren Materials unter der Fotolackschicht (28; 60") umfasst, und wobei der Schritt des Bildens der Öffnung (35; 42) Folgendes umfasst:
Ausführen eines fotolithografischen Verfahrens, um selektive Abschnitte der Fotolackschicht (28; 60") zu entfernen, bis die erste Opferschicht (60') erreicht ist; und
isotropisches Ätzen der ersten Opferschicht (60`), indem ein hinterschnittenes Gebiet (65) zwischen der Fotolackschicht (28; 60") und dem Halbleiterkörper (5) gebildet wird.

3. Verfahren nach Anspruch 1 oder Anspruch 2, wobei der Schritt des Abscheidens der einen oder mehreren Metallschichten das Bilden eines Stapels umfasst, der mindestens eine Metallzwischenschicht (22a) in Kontakt mit der Heterostruktur (17) und mindestens eine Metallfüllschicht (22b) auf der Metallzwischenschicht (22a) enthält.

4. Verfahren nach Anspruch 3, wobei der Schritt des Bildens der Metallzwischenschicht (22a) das Abscheiden einer Schicht aus einem Material, ausgewählt aus Titan und Tantal, enthält; und der Schritt des Bildens der Metallfüllschicht (22b) das Abscheiden einer Aluminiumschicht enthält.

5. Verfahren nach einem der vorhergehenden Ansprüche, ferner umfassend den Schritt des Ausführens eines Verfahrens der schnellen thermischen Ausheilung, RTA, der einen oder mehreren Metallschichten.

6. Verfahren nach Anspruch 5, wobei das RTA-Verfahren bei einer Temperatur im Bereich zwischen 450 °C und 650 °C ausgeführt wird.

## Revendications

1. Procédé de fabrication d'un contact ohmique (22) pour un dispositif HEMT (1), comprenant les étapes suivantes :
- former une structure sacrificielle (28 ; 60) sur un corps semi-conducteur (5) comprenant une hétérostructure (17) ;
- former dans la structure sacrificielle (28 ; 60) une ouverture (35 ; 42) à travers laquelle une région de surface (19) du corps semi-conducteur (5) est exposée au niveau de ladite hétérostructure (17) ;
- graver la région de surface (19) du corps semi-conducteur (5) en utilisant ladite structure sacrificielle (28 ; 60) comme masque de gravure pour former une tranchée (42) dans l'hétérostructure (17) ;
- déposer une ou plusieurs couches de métal (22a, 22b ; 22) dans ladite tranchée (42) et sur la structure sacrificielle (28 ; 60) ; et
- exécuter un processus de levage de la structure sacrificielle (28 ; 60),
dans lequel le corps semi-conducteur (5) comprend un substrat (12), une couche de canal (14) sur le substrat (12), une couche de barrière (16) sur la couche de canal (14), et une couche de protection (18) sur la couche de barrière (16) configurée pour protéger la couche de barrière (16) des phénomènes d'oxydation,
ladite tranchée (42) étant formée à travers l'épaisseur de la couche de protection (18) et à travers au moins une partie de la couche de barrière (16),
la structure sacrificielle (28 ; 60) étant formée sur la couche de protection (18),
dans lequel la structure sacrificielle (28 ; 60) comprend une couche de résine photosensible (28 ; 60"), et l'étape de dépôt desdites une ou plusieurs couches de métal (22a, 22b ; 22) comprend le fait d'utiliser la couche de résine photosensible (28 ; 60") comme masque de dépôt,
dans lequel l'étape d'utilisation de la couche de résine photosensible (28) comme masque de dépôt comprend le fait de façonner la couche de résine photosensible afin de former une ouverture débouchante dans la couche de résine photosensible, ladite ouverture débouchante étant délimitée par des parois latérales inclinées (28') qui donnent à la couche de résine photosensible (28) une forme tronconique avec une base plus grande au niveau de la couche de protection (18), les parois latérales inclinées étant inclinées par rapport à une direction verticale (Z),
et dans lequel le dépôt d'une ou plusieurs couches de métal (22a, 22b ; 22) dans ladite tranchée (42) est réalisé substantiellement le long de ladite direction verticale (Z), de sorte que la projection des parois latérales inclinées (28') permet la formation desdites une ou plusieurs couches de métal (22a, 22b ; 22) dans la tranchée (42) qui ne sont pas en contact direct avec les parois latérales inclinées (28'), ni avec les parois latérales de la couche de protection (18) et de la couche de barrière (16) sous-jacentes.

2. Procédé selon la revendication 1, dans lequel l'étape de formation de la structure sacrificielle (60) comprend en outre la formation d'une couche sacrificielle (60') faite d'un matériau non photosensible sous la couche de résine photosensible (28 ; 60"),
et dans lequel l'étape de formation de ladite ouverture (35 ; 42) comprend les opérations suivantes :
exécuter un processus photolithographique pour retirer des parties sélectives de la couche de résine photosensible (28 ; 60"), jusqu'à atteindre la première couche sacrificielle (60') ; et
attaquer de façon isotrope la première couche sacrificielle (60') en formant une région de dégagement (65) entre la couche de résine photosensible (28 ; 60") et le corps semi-conducteur (5).

3. Procédé selon la revendication 1 ou 2, dans lequel l'étape de dépôt desdites une ou plusieurs couches de métal comprend la formation d'un empilement comportant au moins une couche d'interface métallique (22a) en contact avec ladite hétérostructure (17) et au moins une couche de remplissage métallique (22b) sur la couche d'interface métallique (22a).

4. Procédé selon la revendication 3, dans lequel l'étape de formation de la couche d'interface métallique (22a) comprend le fait de déposer une couche d'un matériau choisi parmi le titane et le tantale ; et l'étape de formation de la couche de remplissage métallique (22b) comprend le fait de déposer une couche d'aluminium.

5. Procédé selon l'une quelconque des revendications précédentes, comprenant en outre l'étape consistant à exécuter un processus de recuit thermique rapide, RTA, desdites une ou plusieurs couches de métal.

6. Procédé selon la revendication 5, dans lequel le processus RTA est exécuté à une température comprise entre 450 °C et 650 °C.
